# EUROPEAN PATENT APPLICATION

(11) **EP 4 180 155 A1**
(43) Date of publication of application: **17.05.2023**
(21) Application number: 20943977.7
(22) Date of filing: 09.07.2020
(51) Int. Cl.: B23B 27/14, B23B 27/20

(54) **DIAMOND-COATED TOOL**

(71) Applicant: Sumitomo Electric Hardmetal Corp., Itami-shi, Hyogo 664-0016 (JP)
(72) Inventor: SUGIMOTO, Rintaro, Itami-shi, Hyogo 664-0016 (JP); HARADA, Takashi, Itami-shi, Hyogo 664-0016 (JP)
(74) Representative: Boult Wade Tennant LLP
(86) International application number: PCT/JP2020/026824
(87) International publication number: WO 2022/009374

(57) **Abstract**

A diamond-coated tool comprising a base material made of a cemented carbide and a diamond layer disposed on the base material, wherein when a cross section of the diamond layer along a normal line to a surface of the diamond layer is observed using a scanning electron microscope, the diamond layer has an average void area ratio of 0% or more and 0.2% or less in a region R surrounded by an interface S 1 between the base material and the diamond layer and a virtual surface Q that is located at a distance of 5 µm from interface S 1 toward a surface side of the diamond layer.

## Description

### TECHNICAL FIELD

The present disclosure relates to a diamond-coated tool.

### BACKGROUND ART

Diamond has a very high hardness, and the smooth surface thereof has an extremely low coefficient of friction. Therefore, a natural single crystal diamond and an artificial diamond powder have conventionally been applied to tool applications. Further, since a technique for forming a diamond thin film by a chemical vapor deposition (CVD) method was established in the 1980s, a cutting tool and a wear-resistant tool in which a diamond coating is formed on a three-dimensionally shaped base material (hereinafter, these tools are also referred to as "diamond-coated tools") have been developed.

WO 2018/174139 (PTL 1) discloses a diamond-coated cemented carbide cutting tool in which a diamond film is formed on a cemented carbide substrate.

### CITATION LIST

### PATENT LITERATURE

PTL 1: WO 2018/174139

### SUMMARY OF INVENTION

The diamond-coated tool of the present disclosure is
a diamond-coated tool comprising a base material made of a cemented carbide and a diamond layer disposed on the base material, wherein
when a cross section of the diamond layer along a normal line to a surface of the diamond layer is observed using a scanning electron microscope, the diamond layer has an average void area ratio of 0% or more and 0.2% or less in a region R surrounded by an interface S1 between the base material and the diamond layer and a virtual surface Q that is located at a distance of 5 µm from the interface S1 toward a surface side of the diamond layer.

### BRIEF DESCRIPTION OF DRAWINGS

Fig. 1 is a diagram illustrating a typical configuration example of the diamond-coated tool according to a first embodiment.
Fig. 2 is an example of a scanning electron microscope image of a cross section of the diamond-coated tool according to the first embodiment.
Fig. 3 is an image obtained by carrying out image processing of the scanning electron microscope image of Fig. 2.
Fig. 4 is a diagram illustrating another typical configuration example of the diamond-coated tool according to the first embodiment.

### DETAILED DESCRIPTION

### [Problem to be Solved by the Present Disclosure]

There is an expanding demand for a diamond-coated tool as a tool for machining a difficult-to-cut material such as carbon fiber reinforced plastics (CFRP), for which the demand is increasing in the aircraft industry or the like, a non-metal, glass, a cemented carbide, which is a hard brittle material for a mold, or a ceramic.

In recent years, the requirement for high-efficiency machining has become stricter, and high-efficiency machining is also required for machining of the above difficult-to-cut material.

Therefore, the present object is to provide a diamond-coated tool that can have a long tool life even in high-efficiency machining of a difficult-to-cut material.

### [Advantageous Effect of the Present Disclosure]

According to the above embodiment, the diamond-coated tool can have a long tool life even in high efficiency machining of a difficult-to-cut material.

### [Description of Embodiments]

First, embodiments of the present disclosure will be listed and described.
(1) The diamond-coated tool of the present disclosure is
   a diamond-coated tool comprising a base material made of a cemented carbide and a diamond layer disposed on the base material, wherein
   when a cross section of the diamond layer along a normal line to a surface of the diamond layer is observed using a scanning electron microscope, the diamond layer has an average void area ratio of 0% or more and 0.2% or less in a region R surrounded by an interface S1 between the base material and the diamond layer and a virtual surface Q that is located at a distance of 5 µm from the interface S1 toward a surface side of the diamond layer.

   According to the above embodiment, the diamond-coated tool can have a long tool life even in high efficiency machining of a difficult-to-cut material.
(2) The arithmetical mean height Sa defined in ISO25178 of the surface on a side of the interface S1 of the base material is preferably 0.5 µm or more and 1.5 µm or less. According to this, the peel resistance of the diamond layer is improved.
(3) The base material contains a plurality of crystal grains, and
   the average grain diameter of the crystal grains is preferably 1 µm or less. According to this, the peel resistance of the diamond layer is improved.
(4) The cemented carbide contains cobalt, and
   the cobalt content of the base material is preferably 10% by mass or less. According to this, the peel resistance of the diamond layer is improved.

### [Details of Embodiments of the Present Disclosure]

First, the present inventors have studied a problem occurring in a conventional diamond-coated tool when the tool is used for high-efficiency machining of a difficult-to-cut material. As a result, the present inventors have newly found a mechanism in which a void is present in the vicinity of the interface between the diamond layer and the base material, a crack occurs starting from the void, and as a result, the diamond layer is peeled off and the tool life is shortened.

Based on the above new finding, the present inventors have assumed that the tool life can be extended by reducing the amount of a void in the vicinity of the interface between the diamond layer and the base material, and as a result of a diligent study, the present inventors have obtained the diamond-coated tool of the present disclosure.

With reference to the drawings, specific examples of the diamond-coated tool of the present disclosure will be described below. In the drawings of the present disclosure, the same reference numerals represent the same parts or equivalent parts. In addition, the dimensional relations of length, width, thickness, depth, and the like are appropriately changed for the purpose of clarifying and simplifying the drawings, and do not necessarily represent the actual dimensional relations.

As used herein, the notation in the form of "A to B" means the upper limit and the lower limit of the range (that is, A or more and B or less), and when there is no description of a unit in A and a unit is set forth only in B, the unit of A and the unit of B are the same.

### [First embodiment: Diamond-coated tool]

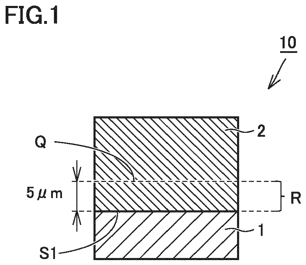

With reference to Fig. 1, the diamond-coated tool according to the first embodiment will be described. As shown in Fig. 1, a diamond-coated tool 10 comprises a base material 1 made of a cemented carbide and a diamond layer 2 disposed on base material 1, and when a cross section along the normal line to the surface of diamond layer 2 is observed using a scanning electron microscope, diamond layer 2 has an average void area ratio (hereinafter, also referred to as the "average void area ratio of the diamond layer") of 0% or more and 0.2% or less in a region R surrounded by an interface S1 between base material 1 and diamond layer 2 and a virtual surface Q that is located at a distance of 5 µm from interface S1 toward the surface side of diamond layer 2.

The diamond-coated tool of the present disclosure can have a long tool life even in high efficiency machining of a difficult-to-cut material. The reason for this is not clear, but it is presumed to be as follows.
(i) The diamond-coated tool of the present disclosure contains a base material made of a cemented carbide. The base material made of a cemented carbide has an excellent balance between hardness and strength. Therefore, a diamond-coated tool using the base material can have a long tool life even in high efficiency machining of a difficult-to-cut material.
(ii) The average void area ratio of the diamond layer of the diamond-coated tool of the present disclosure is 0% or more and 0.2% or less. As used herein, the average void area ratio of the diamond layer is an index representing the proportion of a void in region R in the diamond layer. A smaller average void area ratio indicates fewer voids in the diamond layer. The details of the average void area ratio will be described in the section of "Method for measuring average void area ratio" described later.

When stress is applied to the diamond layer due to cutting resistance during cutting machining, the stress concentrates on the void in the diamond layer.

Therefore, the void in the diamond layer is likely to be the starting point of a crack. When a crack occurs in the diamond layer, the diamond layer is likely to be peeled off.

In the diamond-coated tool of the present disclosure, the average void area ratio of the diamond layer is 0% or more and 0.2% or less, and thus even when stress is applied to the diamond layer due to cutting resistance during cutting machining, a crack generated by the stress concentrating on the void is less likely to occur. Therefore, the diamond-coated tool can have a long tool life even in high efficiency machining of a difficult-to-cut material because the diamond layer is less likely to be peeled off.

The diamond-coated tool can include any other configuration in addition to the base material and the diamond layer. The entire surface of the base material is preferably coated with the diamond layer, and at least the cutting edge portion of the base material is preferably coated therewith.

### <Base material>

### (Composition)

The base material of the diamond-coated tool of the present disclosure is made of a cemented carbide. As the cemented carbide, a known cemented carbide can be used. Examples of the cemented carbide include a tungsten carbide (WC)-base cemented carbide, a cemented carbide containing WC and cobalt (Co), and a cemented carbide obtained by adding a carbonitride or the like of titanium (Ti), tantalum (Ta), (niobium) Nb, or the like to WC, and a cemented carbide obtained by adding a carbonitride or the like of tantalum (Ta), (niobium) Nb, or the like to WC and Co. The base material may contain an unavoidable impurities together with a cemented carbide as long as the advantageous effects of the present disclosure are achieved.

### (Cobalt content)

When the cemented carbide contains cobalt, the cobalt content of the base material is preferably 10% by mass or less. When a diamond layer is formed on the base material, the surface of the base material is usually subjected to an etching treatment. Thereby, the surface roughness of the base material is increased to improve the close adhesion force between the base material and the diamond layer. In the etching treatment, for example, an acid solution treatment with a hydrogen peroxide solution (H₂O₂), hydrochloric acid (HCl), nitric acid (HNO₃), or the like is carried out.

If the cemented carbide contains cobalt, when the base material is subjected to an etching treatment, cobalt on the treated surface of the base material is torn out. When a large amount of cobalt is torn out, a diamond seed crystal is less likely to adhere to the surface of the base material, the average void area ratio of the diamond layer is increased, and the peel resistance tends to be lowered. When the cobalt content of the base material is 10% by mass or less, the average void area ratio of the diamond layer is sufficiently reduced, and thus the peel resistance of the diamond layer is further improved.

The upper limit of the cobalt content of the base material can be 10% by mass or less, 9% by mass or less, or 8% by mass or less. The lower limit of the cobalt content of the base material can be 0% by mass or more, 3% by mass or more, 4% by mass or more, or 5% by mass or more. The cobalt content of the base material can be 0% by mass or more and 10% by mass or less, 3% by mass or more and 10% by mass or less, 4% by mass or more and 9% by mass or less, or 5% by mass or more and 8% by mass or less.

The method for measuring the cobalt content of the base material is as follows. An arbitrary amount of the base material in a region 50 µm or more and 10000 µm or less away from the interface between the base material and the diamond layer toward the base material side is cut out. The cut-out base material is pulverized, then dissolved with an acid, and subjected to inductively coupled plasma (ICP) emission analysis (measuring apparatus: "ICPS-8100" (trademark) manufactured by Shimadzu Corporation) according to JISK 0116:2014 to measure the cobalt content. Any metal standard solution is used as the standard sample.

### (Arithmetical mean height Sa)

The arithmetical mean height Sa defined in ISO25178 of the surface on the interface S1 side of the base material (hereinafter, also referred to as "arithmetical mean height Sa of the base material") is preferably 0.5 µm or more and 1.5 µm or less. Here, the arithmetical mean height Sa defined in ISO25178 is a parameter obtained by extending an arithmetical mean roughness Ra (arithmetical mean height of a line) to a plane, and represents the mean of the absolute values of differences in height between points with respect to the mean plane of the surface.

When the arithmetical mean height Sa of the base material is 0.5 µm or more, the adhesion rate of a diamond seed crystal is sufficient, the nucleation density is increased, and the average void area ratio is reduced, and thus the peel resistance of the diamond layer is further improved. When the arithmetical mean height Sa of the base material is 1.5 µm or less, diamonds growing from diamond seed crystals are likely to be bonded in the interface direction, and the average void area ratio is reduced, and thus the peel resistance of the diamond layer is further improved.

The lower limit of the arithmetical mean height Sa of the base material can be 0.5 µm or more, 0.6 µm or more, or 0.7 µm or more. The upper limit of the arithmetical mean height Sa of the base material can be 1.5 µm or less, 1.4 µm or less, or 1.3 µm or less. The arithmetical mean height Sa of the base material can be 0.5 µm or more and 1.5 µm or less, 0.6 µm or more and 1.4 µm or less, or 0.7 µm or more and 1.3 µm or less.

The method for measuring the arithmetical mean height Sa of the base material is as follows. A diamond indenter is forced into the surface on the diamond layer side of the diamond-coated tool with a test load of 150 kgf of scale C HRC according to the Rockwell hardness test method defined in JIS Z 2245. Thereby, the diamond layer at and around the forcing location is distorted, the diamond layer in this region is peeled off, and the surface on the diamond layer side of the base material is exposed. The arithmetical mean height Sa of the exposed surface of the base material is measured using a laser microscope ("OPTELICS HYBRID" (trademark) manufactured by Lasertech Corporation) according to ISO25178-2:2012 and ISO25178-3:2012. By this method, the arithmetical mean height Sa can be measured without affecting the surface texture on the diamond layer side of the base material.

### (Average grain diameter of crystal grain)

The base material contains a plurality of crystal grains, and the average grain diameter of the crystal grains is preferably 1 µm or less. When the average grain diameter of the crystal grains is 1 µm or less, diamonds growing from diamond seed crystals are likely to be bonded in the interface direction, and the average void area ratio is reduced, and thus the peel resistance of the diamond layer is further improved. As used herein, the "average grain diameter" means the median diameter (d50) in a volume-based grain size distribution (volume distribution).

The upper limit of the average grain diameter of the crystal grains can be 1 µm or less, 0.9 µm or less, or 0.8 µm or less. The lower limit of the average grain diameter of the crystal grains can be 0.3 µm or more, 0.4 µm or more, or 0.5 µm or more. The average grain diameter of the crystal grains can be 0.3 µm or more and 1 µm or less, 0.4 µm or more and 0.9 µm or less, or 0.5 µm or more and 0.8 µm or less.

The method for measuring the grain diameter of each crystal grain for calculating the average grain diameter of the crystal grains is as follows. First, a cross section of the base material is mirror-polished, and a backscattered electron image of an arbitrary region (measurement field of view of 2 µm × 2 µm) on the polished surface is observed at a magnification of 5000 times using an electron microscope. Next, in this backscattered electron image, the diameter of a circle circumscribing the crystal grain (that is, the equivalent circumscribed circle diameter) is measured, and the diameter is defined as the grain diameter of the crystal grain.

### (Thickness of base material)

The thickness of the base material is not particularly limited, and can be, for example, 50 µm or more and 50000 µm or less, 100 µm or more and 20000 µm or less, or 150 µm or more and 10000 µm or less.

Herein, the "thickness of the base material" is measured by the following procedure. A diamond-coated tool is cut out using a wire electric discharge machine along the normal line to the surface of the diamond layer to expose a cross section. The thickness of the diamond layer is measured by observing the same in the cross section using an SEM (scanning electron microscope, "JEM-2100F/Cs" (trademark) manufactured by JEOL Ltd.). Specifically, the observation magnification of a cross-sectional sample is set to 5000 times, the observation field of view area is set to 100 µm², the thickness of the base material is measured at three points in the observation field of view, and the average value of the three points is defined as the thickness of the base material in the observation field of view. The measurement is carried out in 5 observation fields of view, and the average value of the thickness of the base material in the 5 observation fields is defined as "the thickness of the base material."

### <Diamond layer>

### (Average void area ratio)

When a cross section along the normal line to the surface of the diamond layer of the diamond-coated tool of the present disclosure is observed using a scanning electron microscope, the diamond layer has an average void area ratio of 0% or more and 0.2% or less in a region R surrounded by an interface S1 between the base material and the diamond layer and a virtual surface Q that is located at a distance of 5 µm from interface S1 toward the surface side of the diamond layer.

In the diamond-coated tool of the present disclosure, the average void area ratio of the diamond layer is 0% or more and 0.2% or less, and thus even when stress is applied to the diamond layer due to cutting resistance during cutting machining, a crack generated by the stress concentrating on the void is less likely to occur. Therefore, the diamond-coated tool can have a long tool life even in high efficiency machining of a difficult-to-cut material because the diamond layer is less likely to be peeled off.

The upper limit of the average void area ratio of the diamond layer can be 0.2% or less, 0.19% or less, or 0.18% or less. The lower limit of the average void area ratio of the diamond layer can be 0% or more, 0.0001% or more, or 0.001% or more. The average void area ratio of the diamond layer can be 0% or more and 0.2% or less, 0% or more and 0.19% or less, 0% or more and 0.18% or less, 0.0001% or more and 0.18% or less, or 0.001% or more and 0.18% or less.

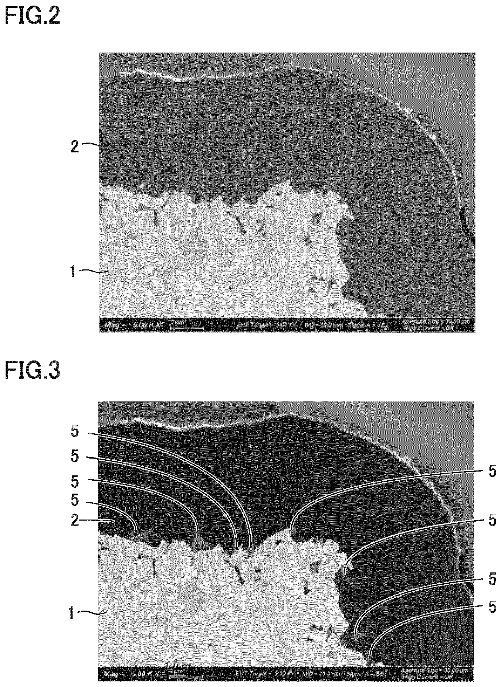

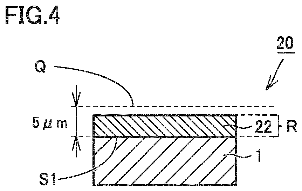

The method for measuring the average void area ratio of the diamond layer is as shown in the following (1-1) to (1-6).
(1-1) The diamond-coated tool is cut out using a wire electric discharge machine such that it passes the cutting edge in the direction along the normal line to the surface of the diamond layer. The exposed cross section is subjected to cross section polisher (CP) machining.
(1-2) The CP machined surface of the diamond-coated tool is imaged with a field of view of 25 µm × 15 µm using an SEM (scanning electron microscope, "JEM-2100F/Cs" (trademark) manufactured by JEOL Ltd.). The field of view (hereinafter, also referred to as the "observation field of view") is set such that the base material and the diamond layer are simultaneously imaged. An example of an SEM image of a cross section of the diamond-coated tool of the present disclosure is shown in Fig. 2.
(1-3) The above SEM image is analyzed using image processing software ("WinROOF 2018" (trademark) manufactured by Mitani Corporation). Utilizing the difference in contrast of a secondary electron or a backscattered electron between the base material and the diamond layer on the SEM image, the base material and the diamond layer are separated by binarization processing to obtain a binarization-processed image. A binarization-processed image of Fig. 2 is shown in Fig. 3.
(1-4) In the above binarization-processed image, when a region shown by a contrast different from that of the surroundings is present in the diamond layer, the region is identified as a void. The void may be shown either whiter or blacker than the surrounding diamond layer. In Fig. 3, voids are indicated by reference sign 5.
(1-5) In the above binarization-processed image, the ratio of the area of the voids to the area of region R surrounded by interface S1 between the base material and the diamond layer and virtual surface Q that is located at a distance of 5 µm from interface S1 toward the surface side of the diamond layer is calculated.
   As shown in Fig. 4, when the thickness of a diamond layer 22 is less than 5 µm, the area of region R is the area of entire diamond layer 22 in the observation field of view.
(1-6) The above ratio of the area of the voids is calculated in 5 observation fields of view, and the average of these is defined as the average void area ratio of the diamond layer.

As far as the applicant has measured, as long as the same sample is measured, even if the average void area ratio of the diamond layer is measured a plurality of times by changing the selection point of a measurement field of view, there is almost no variation in the measurement results, and it has been confirmed that even if the measurement field of view is set arbitrarily, it will not be contrived.

### (Thickness)

The lower limit of the thickness of the diamond layer of the present disclosure can be 3 µm or more, 4 µm or more, or 5 µm or more. The upper limit of the thickness of the diamond layer of the present disclosure can be 35 µm or less 33 µm or less, or 30 µm or less. The thickness of the diamond layer of the present disclosure can be 3 µm or more and 35 µm or less, 4 µm or more and 33 µm or less, or 5 µm or more and 30 µm or less.

Herein, the "thickness of the diamond layer" is measured by the following procedure. A diamond-coated tool is cut out using a wire electric discharge machine along the normal line to the surface of the diamond layer to expose a cross section. The thickness of the diamond layer is measured by observing the same in the cross section using an SEM (scanning electron microscope, "JEM-2100F/Cs" (trademark) manufactured by JEOL Ltd.). Specifically, the observation magnification of a cross-sectional sample is set to 5000 times, the observation field of view area is set to 100 µm², the thickness of the diamond layer is measured at three points in the observation field of view, and the average value of the three points is defined as the thickness of the diamond layer in the observation field of view. The measurement is carried out in 5 observation fields of view, and the average value of the thickness of the diamond layer in the 5 observation fields is defined as "the thickness of the diamond layer."

### (Use)

The diamond-coated tool according to the present embodiment can be usefully used as, for example, a cutting tool such as an indexable cutting insert, a bit, a cutter, a drill, or an end mill, and a wear-resistant tool such as a die, a bending die, a drawing die, or a bonding tool.

In the above, the first embodiment was described using a difficult-to-cut material such as CFRP as a work material, but the work material is not limited to the difficult-to-cut material. Examples of the work material include an aluminum alloy, a cemented carbide, and a ceramic.

### [Second Embodiment: Method for manufacturing diamond-coated tool]

The method for manufacturing the diamond-coated tool of the present disclosure is not particularly limited. The method for manufacturing the diamond-coated tool of the present disclosure can include, for example, a step of preparing a base material (hereinafter, also referred to as a "base material preparation step") and a step of forming a diamond layer on the base material by a chemical vapor deposition method to obtain a diamond-coated tool (hereinafter, also referred to as a "diamond layer formation step").

### (Base material preparation step)

As the base material, the base material according to the first embodiment is prepared. The base material is preferably subjected to a surface treatment such as a sandblasting treatment or an etching treatment. Thereby, an oxide film or a contaminant on the surface of the base material is removed. Further, the surface roughness of the base material is increased to thereby improve the close adhesion force between the base material and the diamond layer.

The sandblasting treatment can be carried out, for example, by projecting SiC having a grain diameter of 30 µm onto the base material at an injection pressure of 0.15 to 0.35 MPa.

For the etching treatment, for example, an acid solution treatment with 30% nitric acid and an alkali treatment with sodium hydroxide (NaOH) or the like are carried out.

### (Diamond layer formation step)

Next, a diamond seed crystal is applied to the surface of the base material to carry out a seeding treatment. At this time, the diamond seed crystal is dispersed in water at a concentration of 0.01 g/L or more, and the base material is immersed in the resulting diamond seed crystal aqueous solution.

The average grain diameter of the diamond seed crystal is preferably 0.005 µm or more and 0.5 µm or less. According to this, the nucleation density of diamond becomes suitable, the average void area ratio of the diamond layer is lowered, and the peel resistance of the diamond layer is improved. Here, the "average grain diameter" means the median diameter (d50) in a volume-based grain size distribution (volume distribution). The particle diameter of each crystal grain for calculating the average grain diameter of the diamond seed crystal is measured using a field emission scanning electron microscope (FE-SEM).

Next, a diamond layer is formed by a CVD method on the surface of the base material on the side on which the diamond seed crystal is seeded to obtain a diamond-coated tool. As the CVD method, a conventionally known CVD method can be used. Examples thereof that can be used include a microwave plasma CVD method, a plasma jet CVD method, and a hot filament CVD method.

For example, a diamond layer can be formed on a base material by disposing a base material in a hot filament CVD apparatus, introducing methane gas and hydrogen gas into the apparatus at a mixing proportion of 0.5:99.5 to 10:90 on a volume basis, and keeping the substrate temperature at 700°C or more and 900°C or less.

### <Supplementary note 1>

In the diamond-coated tool of the present disclosure, the cemented carbide contains cobalt, and the cobalt content of the base material is preferably 0% by mass or more and 10% by mass or less.

The cobalt content of the base material is preferably 3% by mass or more and 10% by mass or less.

The cobalt content of the base material is preferably 4% by mass or more and 9% by mass or less.

The cobalt content of the base material is preferably 5% by mass or more and 8% by mass or less.

### <Supplementary note 2>

In the diamond-coated tool of the present disclosure, the arithmetical mean height Sa defined in ISO25178 of the surface on the interface S1 side of the base material is preferably 0.6 µm or more and 1.4 µm or less.

The arithmetical mean height Sa is preferably 0.7 µm or more and 1.3 µm or less.

### <Supplementary note 3>

In the diamond-coated tool of the present disclosure, the base material contains a plurality of crystal grains, and the average grain diameter of the crystal grains is preferably 0.3 µm or more and 1 µm or less.

The average grain diameter is preferably 0.4 µm or more and 0.9 µm or less.

The average grain diameter is preferably 0.5 µm or more and 0.8 µm or less.

### <Supplementary note 4>

In the diamond-coated tool of the present disclosure, the average void area ratio of the diamond layer is preferably 0% or more and 0.19% or less.

The average void area ratio is preferably 0% or more and 0.18% or less.

The average void area ratio is preferably 0.0001% or more and 0.18% or less.

The average void area ratio is preferably 0.001% or more and 0.18% or less.

### <Supplementary note 5>

The thickness of the diamond layer of the present disclosure is preferably 3 µm or more and 35 µm or less.

The thickness is preferably 4 µm or more and 33 µm or less.

The thickness is preferably 5 µm or more and 30 µm or less.

### EXAMPLES

The present embodiments will be described more specifically with reference to Examples. However, the present embodiments are not limited by these Examples.

### [Sample 1 to sample 8]

### <Creation of diamond-coated tool>

Base materials having a material of a WC-base cemented carbide and in the shape of an end mill (ϕ6 mm, model number: SSDC4060) were prepared. The cobalt content of each of the base materials and the average grain diameter of the crystal grain contained in each of the base materials are shown in the "Co content (% by mass)" column and the "Average grain diameter (µm)" column, respectively, of the "Base material" in Table 1. For example, in sample 1, the Co content of the base material was 5% by mass, and the average grain diameter of the crystal grain contained in the base material was 0.7 µm.

Each of the base materials was subjected to an acid treatment (solution: 30% nitric acid), and the surface of the base material was subjected to an etching treatment. Subsequently, the surface of the base material was subjected to a blasting treatment and an alkali treatment to form unevenness on the surface of the base material.

Subsequently, a diamond seed crystal was applied to the surface of the base material, and then the base material was cleaned in ethanol, dried, and subjected to a seeding treatment. The average grain diameter of the diamond seed crystal used in each of the samples is shown in the "Average grain diameter (µm)" column of "Diamond seed crystal" in Table 1. For example, in sample 1, the average grain diameter of the diamond seed crystal was 0.1 µm.

Next, the base material subjected to the above seeding treatment was set in a known hot filament CVD apparatus.

The diamond layer of each of the samples was formed under the following conditions. The filament current was controlled such that the base material temperature was the temperature shown in the "Base material temperature (°C)" column of the "Film formation conditions" in Table 1. The flow rates of methane and hydrogen were controlled such that the methane concentration was the concentration shown in the "Methane concentration (%)" column of "Film formation conditions" in Table 1 on a volume basis. For all the samples, the pressure at the time of film formation was 500 mPa. The film was formed until the thickness of the diamond layer reached 10 µm. For example, in sample 1, the base material temperature was 750°C, and the methane concentration was 1% by volume.

The diamond-coated tool for each of the samples was obtained by the above steps.

### [Table 1]

**Table 1**

| Sampl e No. | Film formation conditions | | Diamon d seed crystal | Base material | | | Diamon d layer | Cuttin g test |
|---|---|---|---|---|---|---|---|---|
| | Methane concentratio n (% by volume) | Base material temperatur e (°C) | Average grain diameter (µm) | Co conten t (% by mass) | Average grain diamete r (µm) | Sa (µm ) | Average void area ratio (%) | Life (m) |
| 1 | 1 | 750 | 0.1 | 5 | 0.7 | 0.9 | 0.09 | 142 |
| 2 | 3 | 800 | 0.05 | 8 | 0.5 | 0.7 | 0.05 | 158 |
| 3 | 2 | 800 | 0.01 | 10 | 0.8 | 1.1 | 0.12 | 124 |
| 4 | 3 | 780 | 0.5 | 6 | 1 | 0.6 | 0.15 | 108 |
| 5 | 2 | 800 | 1 | 5 | 0.5 | 0.7 | 0.31 | 68 |
| 6 | 1 | 750 | 0.1 | 8 | 1 | 1.7 | 0.53 | 46 |
| 7 | 8 | 800 | 0.05 | 10 | 2 | 0.8 | 0.73 | 16 |
| 8 | 9 | 780 | 0.5 | 12 | 0.7 | 0.4 | 0.25 | 32 |

### <Evaluations>

(Cobalt content of base material, average grain diameter of base material, arithmetical mean height Sa of surface of base material, and average void area ratio of diamond layer)

In each of the samples, the cobalt content of the base material, the average grain diameter of the base material, the arithmetical mean height Sa of the surface of the base material, and the average void area ratio of the diamond layer were measured. These measurement methods have been described in the first embodiment, and thus the description thereof will not be repeated.

It was confirmed that the cobalt content of the base material and the average grain diameter of the base material of each of the samples maintained the cobalt content and the average grain diameter of the base material before forming the diamond layer on the base material.

The arithmetical mean height Sa of the surface of the base material and the average void area ratio of the diamond layer of each of the samples are shown in the "Sa (µm)" column of "Base material" and the "Average void area ratio (%)" column of "Diamond layer" in Table 1, respectively. For example, in sample 1, the arithmetical mean height Sa on the surface of the base material was 0.9 µm, and the average void area ratio of the diamond layer was 0.09%.

### (Cutting test)

The diamond-coated tool (end mill) of each of the samples was cut under the following conditions.
Work material: Carbon Fiber Reinforced Plastics (CFRP), size: 150 mm × 300 mm × 6 mm
Cutting speed Vc: 200 m/min
Feed speed f: 0.3 mm/rev
Axial depth of cut, ap: 8 mm
Lateral depth of cut, ae: 6 mm
Cutting oil: Yes

In the above cutting test, the cutting distance until the base material was exposed by peeling off or wear of the diamond layer on the cutting edge was measured. A longer cutting distance indicates a longer tool life. Results are shown in the "Distance" column of the "Cutting test" in Table 1.

### <Evaluations>

The diamond-coated tools of samples 1 to 4 correspond to Examples. The diamond-coated tools with coated surfaces of samples 5 to 8 correspond to Comparative Examples. It was confirmed that samples 1 to 4 (Examples) had a longer cutting distance and a longer tool life than samples 5 to 8 (Comparative Examples).

In samples 1 to 4, the average void area ratio of the diamond layer is 0% or more and 0.2% or less, and thus it is presumed that even when stress is applied to the diamond layer due to cutting resistance during cutting machining, a crack generated by the stress concentrating on the void is less likely to occur, and thus the diamond layer is less likely to be peeled off, and the tool life is long.

In samples 5 to 8, the average void area ratio of the diamond layer is more than 0.2%, and thus it is presumed that when stress is applied to the diamond layer due to cutting resistance during cutting machining, a crack starting from a void is generated by the stress concentrating on the void, the diamond layer is likely to be peeled off, and the tool life is short.

Although the embodiments and the Examples of the present disclosure have been described as described above, it is also intended from the beginning that the configurations of the above embodiments and Examples may be appropriately combined or variously altered.

It should be understood that the embodiments and the Examples disclosed this time are illustrative in all respects and non-limiting. The scope of the present invention is not shown by the embodiments and the Examples described above but by the claims, and is intended to include all modifications within the meaning and the scope equivalent to the claims.

### REFERENCE SIGNS LIST

1: base material, 2, 22: diamond layer, 5: void, 10, 20: diamond-coated tool, S1: interface S1, Q: virtual surface Q, R: region R

## Claims

1. A diamond-coated tool comprising a base material made of a cemented carbide and a diamond layer disposed on the base material, wherein
when a cross section of the diamond layer along a normal line to a surface of the diamond layer is observed using a scanning electron microscope, the diamond layer has an average void area ratio of 0% or more and 0.2% or less in a region R surrounded by an interface S1 between the base material and the diamond layer and a virtual surface Q that is located at a distance of 5 µm from the interface S1 toward a surface side of the diamond layer.

2. The diamond-coated tool according to claim 1, wherein an arithmetical mean height Sa defined in ISO25178 of a surface on a side of the interface S1 of the base material is 0.5 µm or more and 1.5 µm or less.

3. The diamond-coated tool according to claim 1 or claim 2, wherein
the base material comprises a plurality of crystal grains, and
an average grain diameter of the crystal grains is 1 µm or less.

4. The diamond-coated tool according to any one of claim 1 to claim 3, wherein
the cemented carbide comprises cobalt, and
a cobalt content of the base material is 10% by mass or less.
